# EUROPÄISCHE PATENTANMELDUNG

(11) **EP 3 816 840 A1**
(43) Veröffentlichungstag der Anmeldung: **05.05.2021**
(21) Anmeldenummer: 19206589.4
(22) Anmeldetag: 31.10.2019
(51) Int. Cl.: G06F 30/13, E04B 1/00

(54) **VERFAHREN UND EINRICHTUNG ZUR RECHNERGESTÜTZTEN AUSWAHL UND POSITIONIERUNG VON BETONTEIL-VERBINDUNGSELEMENTEN**

(71) Anmelder: Schöck Bauteile GmbH, 76534 Baden-Baden (DE)
(72) Erfinder:
(74) Vertreter: König Szynka Tilmann von Renesse Patentanwälte Partnerschaft mbB

(57) **Zusammenfassung**

Die Erfindung betrifft ein Verfahren und eine Einrichtung zur rechnergestützten Auswahl und Positionierung von Betonteil-Verbindungselementen (1, la, lb), die zwischen einem von einem Gebäude (2) auskragenden Betonteil (3) und einer Gebäudefassade (4) angeordnet werden, umfassend die folgenden Schritte:
- Erstellung (A) einer statischen Planung für ein an einer Gebäudefassade (4) anzubringendes auskragendes Betonteil (3) mit Ausgabe des Momenten- und Querkraftverlaufes,
- Auswahl (B) von zu dem Momenten- und Querkraftverlauf passenden Betonteil-Verbindungselementen (1a', 1b') und Erstellung eines statisch gültigen vorläufigen Einbauplans (21) auf Basis des Momenten- und Querkraftverlaufes,
- Modifikation (C) des vorläufigen Einbauplans (21) durch einen Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (31) Werte einer hinsichtlich mehrerer Dimensionierungskriterien (P1 - P5) parametrierbaren Gütefunktion ermittelt und den vorläufige Einbauplan (21) derart im Rahmen der statischen Gültigkeit abwandelt, dass die Gütefunktion ein Maximum annimmt.

## Beschreibung

Die vorliegende Erfindung betrifft ein Verfahren sowie eine Einrichtung zur rechnergestützten Auswahl und Positionierung von Betonteil-Verbindungselementen, die zwischen einem von einem Gebäude auskragenden Betonteil und einer Gebäudefassade angeordnet werden. Außerdem betrifft die Erfindung auch eine Einrichtung zur Durchführung des Verfahrens sowie ein das Verfahren verkörperndes Computerprogramm sowie einen dieses beinhaltenden Datenträger.

Das Einsatzgebiet der Erfindung ist die Bautechnik, insbesondere in Bezug auf die Umsetzung einer statischen Planung eines von einem Gebäude auskragenden Betonteils, beispielsweise eines Fertigteilbalkons, in eine den bautechnischen Vorschriften und konstruktiven Randbedingungen entsprechende Ausführungsplanung.

Als Betonteil-Verbindungselement kommt im Rahmen der vorliegenden Erfindung insbesondere ein allgemein bekanntes tragendes Wärmedämmelement in Betracht, welcher als eine Art einbetonierbares Brückenelement die gewünschte Verbindung einfach und sicher herstellt. Mit anderen Worten dient ein solches Betonteil-Verbindungselement dabei als Anschlussteil, mit dem sich auch die erforderliche thermische Trennung sowie Wärmedämmung der miteinander zu verbindenden Teile, nämlich dem auskragenden Betonteil und die Gebäudefassade des Gebäudes, realisieren lässt. Insoweit besteht das LK:
Betonteil-Verbindungselement im Wesentlichen aus einem Dämmkörper und einem Drucklager aus vorzugsweise Hochleistungs-Feinbeton und mehreren den Dämmkörper durchdringenden Armierungsstäben mit freibleibenden Enden, die einerseits seitens der Gebäudefassade im Bereich einer Betondecke und andererseits am auskragenden Gebäudeteil einbetoniert sind. Daneben kommen noch auf diesem Grundprinzip basierende andere Betonteil-Verbindungselemente zum Einsatz, welche zumindest einseitig mit den besagten Armierungsstäben ausgestattet sind. Auch diese ähnlichen Betonteil-Verbindungselemente sind von der nachfolgend beschriebenen Erfindung mit umfasst.

### Stand der Technik

Im Rahmen der Ausführungsplanung für die konkrete Auswahl und Positionierung gattungsgemäßer Betonteil-Verbindungselemente ist gemäß dem allgemein bekannten Stand der Technik nach Maßgabe des aus der statischen Planung resultierenden Momenten- und Querkraftverlaufs zu dimensionieren. Dies bedeutet, dass aus verschiedenen Varianten von Betonteil-Verbindungselementen diejenigen auszusuchen sind, welche den konkreten statischen Erfordernissen entsprechen, also hinsichtlich der aufnehmbaren Lasten und der geometrischen Abmessungen passend sind. Jedoch können in der Praxis oftmals die aus statischen Gesichtspunkten optimalen Verbindungsstellen nicht mit einem Betonteil-Verbindungselement bestückt werden, da dann beispielsweise vorgeschriebene Mindestrandabstände zu Gebäudekanten oder dergleichen eingehalten werden können. Hieraus resultiert auch die Gefahr, dass erst auf der Baustelle im Zuge der Montage bemerkt wird, dass eine vormontierte Baueinheit als beispielsweise Balkon mit Betonteil-Verbindungselementen so nicht montierbar ist, woraus ein erheblicher Nachbearbeitungsaufwand resultieren kann.

Es ist daher die Aufgabe der vorliegenden Erfindung, ein Verfahren sowie eine Einrichtung zur rechnergestützten Auswahl und Positionierung von Betonteil-Verbindungselement zu schaffen, welche in einfacher Weise eine in Bezug auf die vorstehend geschilderte Problematik fehlerfreie Ausführungsplanung ermöglicht.

### Offenbarung der Erfindung

Die Aufgabe wird verfahrenstechnisch durch Anspruch 1 gelöst. Der Anspruch 10 gibt eine das Verfahren ausführende rechnergestützte Einrichtung an. Ferner beinhaltet der Anspruch 12 ein das erfindungsgemäße Verfahren verkörperndes Computerprogramm, das auf einem computerlesbaren Datenträger gemäß Anspruch 13 abspeicherbar hinterlegt ist.

Die Erfindung schließt die verfahrenstechnische Lehre ein, zur rechnergestützten Auswahl und Positionierung von Betonteil-Verbindungselementen, die zwischen einem von einem Gebäude auskragenden Betonteil und einer Gebäudefassade angeordnet werden, die nachfolgenden Schritte computergestützt durchgeführt werden:
- Erstellung einer statischen Planung für ein an einer Gebäudefassade anzubringendes auskragendes Gebäudeteil mit Ausgabe des Momenten- und Querkraftverlaufs;
- Auswahl von zu dem Momenten- und Querkraftverlauf passenden Betonteil-Verbindungselementen und Erstellung eines statisch gültigen vorläufigen Einbauplans auf Basis des Momenten- und Querkraftverlaufs;
- Modifikation des vorläufigen Einbauplans durch einen Abwandlungsalgorithmus zur Erzeugung eines alternativen Einbauplans, wobei der Abwandlungsalgorithmus zur Abwandlung des vorläufigen Einbauplans in den alternativen Einbauplan Werte einer hinsichtlich mehrerer Dimensionierungskriterien parametrierbaren Gütefunktion ermittelt und den vorläufigen Einbauplan derart im Rahmen der statischen Gültigkeit abwandelt, dass die Gütefunktion ein Maximum annimmt.

Mit anderen Worten stellt die erfindungsgemäße Lösung somit eine Art Assistenzsystem bereit, welches den Planer zum einen darin unterstützt, aus einer Vielzahl unterschiedlicher Varianten von Betonteil-Verbindungselementen und möglichen Positionierungen die effizienteste Lösung herauszufinden, und - im Sinne einer weiteren Dimension - dabei andererseits auch alle relevanten bautechnischen Vorschriften, wie Gebäuderandabstände, Mindestabstände zwischen benachbarten Armierungsstäben und dergleichen, zu beachten. Die vorstehend geschilderte Problematik zeigt, dass bislang auftretende Fehler durch eine manuelle Planung nicht zu beherrschen sind. Somit zeichnet sich das erfindungsgemäße Assistenzsystem durch eine Fehlervermeidung sowie eine Verkürzung der Planungszeit bei der Dimensionierung sowie auch einer Verkürzung der Montagezeit auf der Baustelle aus, da Nacharbeiten aufgrund von Planungsfehlern vermieden werden.

Der die angegebene Gütefunktion beinhaltende erfindungswesentliche Abwandlungsalgorithmus erweist sich als in der Lage, die vorstehend beschriebene mehrdimensionale Problematik zu beherrschen. Denn in der mathematischen Gütefunktion ist das Ziel verkörpert, welches mit der Abwandlung erreicht werden soll, beispielsweise die Beachtung hinreichender Randabstände oder die Einhaltung von Mindestabständen von Bauteilen untereinander. Falls mehrere Ziele gleichzeitig erreicht werden sollen, so bietet dieses mathematische Modell die Voraussetzung dafür, dass im Falle von Zielkonflikten Kompromisse im Sinne eines kleinsten gemeinsamen Nenners auffindbar sind.

Pro vorläufigem Einbauplan kann eine Auswertung in mehreren Durchläufen stattfinden, welche mit der Gütefunktion getestet werden. Zur Suche der jeweils nächsten Variante kann ein beliebiges Optimierungsverfahren genutzt werden, das aus der Vorgeschichte der bisherigen Varianten eine neue Variante mit voraussichtlich besserem Wert der Gütefunktion ableitet. Dabei berücksichtigt der Abwandlungsalgorithmus auch gleichzeitig, dass die ermittelten Varianten stets im Rahmen der statischen Gültigkeit bleiben, das heißt, dass nicht eine Variante vorgeschlagen wird, welche die Grenzen der aufgrund des Momenten- und Querkraftverlaufs vorgegebenen Statikanforderungen verlässt.

Die im Abwandlungsmechanismus implementierte parametrierbare Gütefunktion berücksichtigt vorzugsweise mehrere Dimensionierungskriterien P1 bis P5, welche maßliche, materielle und/oder modellmäßige Kriterien darstellen. Ein maßliches Kriterium kann dabei ein Abstandsmaß zwischen benachbarten Bauteilen oder die Geometrie eines Bauteils sein. Ein materielles Kriterium repräsentiert den Werkstoff, aus dem das Betonteil-Verbindungselement, die angrenzenden Bauteile oder der zum Einbetonieren verwendete Beton besteht. Denn dies hat ebenfalls einen maßgeblichen Einfluss auf die Belastbarkeit. Als modellmäßige Kriterien kommen verschiedene Varianten von Betonteil-Verbindungselementen infrage, welche in der Regel als Baukastensystem bereitgestellt werden.

Die mehreren Dimensionierungskriterien stehen dem Planer - beispielsweise mittels eines auf einer grafischen Benutzeroberfläche nachgebildeten Drehreglers - für verschiedene Optimierungsrichtungen einer Eingabemöglichkeit bereit, um gewünschte Gewichtungen für Modifikationen des vorläufigen Einbauplans zu wählen. Das Assistenzsystem ermittelt anhand des Abwandlungsalgorithmus ein aufeinander abgestimmtes, sinnvolles Verhältnis von verschiedenen vorgegebenen Dimensionierungskriterien und schlägt einen zugehörigen alternativen Einbauplan vor. Im einfachsten Fall ist es jedoch auch denkbar, dass nur ein einziges Dimensionierungskriterium vorgebbar ist. Verschiedenste Dimensionierungskriterien P1 bis Pn sind denkbar, wovon nachfolgend eine nicht einschränkende Auswahl angegeben wird:
Ein erstes Dimensionierungskriterium P1 beschreibt eine Auswahl zwischen verschiedenen Modellen von geeigneten Betonteil-Verbindungselementen. So ist es beispielsweise denkbar, dass zwei kleinere Betonteil-Verbindungselemente durch ein einziges, größeres Betonteil-Verbindungselement ersetzt werden können.

Ein zweites Dimensionierungskriterium P2 beschreibt einen vorzugebenden Abstand zwischen benachbarten Betonteil-Verbindungselementen. So können beispielsweise weniger Betonteil-Verbindungselemente vorgegeben werden, falls die verwendeten Betonteil-Verbindungselemente eine entsprechend höhere Traglast aufweisen.

Ein drittes Dimensionierungskriterium P3 dient der Variation des senkrechten Gebäudekantenabstandes zum ersten Armierungsstab eines Betonteil-Verbindungselements. Mit diesem Dimensionierungskriterium kann beispielsweise sichergestellt werden, dass ein hinreichender Abstand zum Einbetonieren der Armierungsstäbe verbleibt.

Ein viertes Dimensionierungskriterium P4 dient der Variation der Armierungsstababstände untereinander, so dass bei einer Verringerung gegebenenfalls eine höhere Traglast desselben Betonteil-Verbindungselements erzielbar ist.

Ein fünftes Dimensionierungskriterium P5 kann für die Optimierung von Positionierungskoordinaten mindestens eines Befestigungshakens für ein Hebezeug am Betonteil dienen. Hierüber ist es möglich, geeignete Angriffspunkte eines Krans oder dergleichen am Betonteil zum Transport auf der Baustelle vorzugeben.

Gemäß einer weiteren die Erfindung verbessernden Maßnahme wird vorgeschlagen, dass die Umwandlung des vorläufigen Einbauplans in den mindestens einen alternativen Einbauplan ein Prüfen desselben auf Zulässigkeit bezüglich baurechtlicher Randbedingungen und/oder technischer Normen beinhaltet, die in einer entsprechenden Vorschriften-Datenbank hinterlegt sind. Hieraus können dem Assistenzsystem die erforderlichen Informationen zur Verfügung gestellt werden, so dass Fehlplanungen in einfacher Weise vermieden werden und sichergestellt ist, dass sämtliche einschlägigen Randbedingungen und Vorschriften beachtet werden.

Darüber hinaus wird gemäß einer weiteren optionalen Maßnahme vorgeschlagen, dass der alternative Einbauplan, welcher schlussendlich zur Realisierung ansteht, in der mit dem Planungsassistenzsystem verbundenen Vorschriften-Datenbank oder einer hierfür speziell vorgesehenen Datenbank hinterlegt wird, um diesen bei zukünftigen Umwandlungen gleicher oder ähnlicher vorläufiger Einbaupläne als Vorlagevorschlag zu berücksichtigen. Dies reduziert die Auswahlzeit für die Realisierung geeigneter Unterlagen für eine Ausführungsplanung weiter.

Darüber hinaus eröffnet die erfindungsgemäße Lösung die Option, einen zu realisierenden alternativen Einbauplan vor tatsächlicher Montage auf der Baustelle einer amtlichen Vorzertifizierung zuzuführen, welche über eine digitale Kommunikationsschnittstelle des Planungssystems realisierbar ist, die einen hierfür vorgesehenen Datenaustausch mit einer zuständigen Behörde oder einem Sachverständigen gestattet und eventuell erforderliche Genehmigungsverfahren vereinfacht.

### Detailbeschreibung anhand der Zeichnung

Weitere die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Fig. 1: eine schematische Darstellung einer Einrichtung zur rechnergestützten Auswahl und Positionierung von Betonteil-Verbindungselementen, und
- Fig. 2: eine Ablaufdarstellung des von der Einrichtung rechnergestützt durchgeführten Verfahrens.

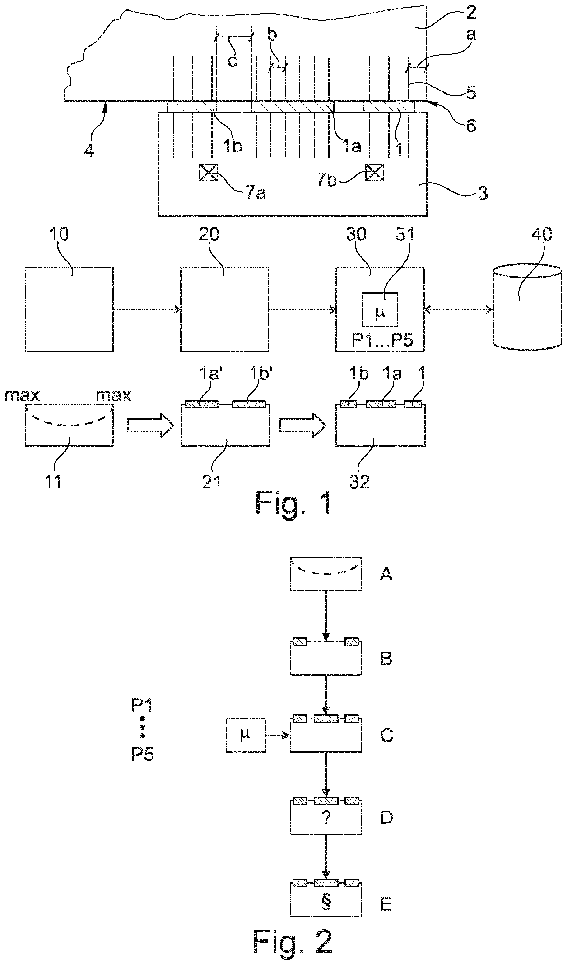

Gemäß Fig. 1 sind für den exemplarischen Anwendungsfall einer Balkonbefestigung Betonteil-Verbindungselemente 1, 1a und 1b vorgesehen, die zwischen einem von einem Gebäude 2 auskragenden Betonteil 3 in Form eines Fertigteilbalkons und einer Gebäudefassade 4 angeordnet. Als Betonteil-Verbindungselemente 1, 1a und 1b werden tragende Wärmedämmelemente verwendet, welche der bauaufsichtlichen Zulassung des DIBt sowie der europäischen technischen Bewertung gemäß EAD 050001-00-0301 entsprechen. Diese Betonteil-Verbindungselemente existieren im Rahmen eines Baukastensystems in verschiedenen Varianten gemäß Herstellernomenklatur.

In diesem Ausführungsbeispiel ist das als rechteckiger Balkon ausgebildete auskragende Betonteil 3 über drei Betonteil-Verbindungselemente 1, 1a und 1b mit jeweils sich zur Seite des Betonteils 3 und zur Seite des Gebäudes 2 erstreckenden Armierungsstäben ausgestattet. Die konkrete Auswahl und Positionierung der Betonteil-Verbindungselemente 1, 1a und 1b hat gemäß den statischen Erfordernissen zu erfolgen. Eine erfindungsgemäße rechnergestützte Einrichtung dient dabei als Assistenzsystem für eine baustellengerechte Ausführungsplanung.

Die Einrichtung umfasst eine Statikplanungseinheit 10, welche auch separat ausgebildet sein kann, zur Erstellung einer statischen Planung für ein an der Gebäudefassade 4 anzubringendes auskragendes Betonteil 3. Die Statikplanungseinheit 10 gibt unter anderem den dimensierungsrelevanten Momenten- und Querkraftverlauf 11 als Planungsergebnis aus.

Eine nachgeschaltete Auswahleinheit 20 dient der Bestimmung von zu dem Momenten- und Querkraftverlauf der vorausgehenden statischen Planung passenden Betonteil-Verbindungselement la' und 1b' für die Erstellung eines statisch gültigen vorläufigen Einbauplans 21, welcher zunächst nicht dem eingangs beschriebenen Einbauplan entspricht.

Eine nachfolgende Modifikationseinheit 30 dient einer anschließenden Abänderung des vorläufigen Einbauplans 21 durch einen hierin implementierten Abwandlungsalgorithmus 31 zur Erzeugung mindestens eines alternativen Einbauplans 32, welcher dem eingangs beschriebenen Einbauplan entspricht.

Der Abwandlungsalgorithmus 31 der Modifikationseinheit 30 wandelt den vorläufigen Einbauplan 21 in den alternativen Einbauplan 32 ab, indem Werte einer hinsichtlich mehrerer Dimensionierungskriterien P1 bis P5 parametrierbare Gütefunktion ermittelt und den vorläufigen Einbauplan 21 derart im Rahmen der statischen Gültigkeit abwandelt, dass die Gütefunktion ein Maximum annimmt. Hierdurch entspricht der alternative Einbauplan 32 ebenfalls den statischen Vorgaben hinsichtlich des geforderten Momenten- und Querkraftverlaufs 11 und beinhaltet außerdem eine insbesondere maßliche, materielle und/oder modellmäßige Optimierung der zum Einsatz kommenden Betonteil-Verbindungselemente 1, 1a und 1b sowie deren Positionierung relativ zum Gebäude 2 und dem hiervon auskragenden Betonteil 3.

Die Statikplanungseinheit 10, die Auswahleinheit 20 sowie die Abwandlungseinheit 30 sind in einem Arbeitsplatzrechner integriert und mit einer Vorschriften-Datenbank 40 verbunden. Hierdurch hat das Assistenzsystem Zugriff auf dimensionierungsrelevante technische Normen sowie baurechtliche Randbedingungen, welche bei der Abwandlung des vorläufigen Einbauplans 21 zu beachten sind.

Nach Fig. 2 führt das vorstehend beschriebene Assistenzsystem zur erfindungsgemäßen Auswahl und Positionierung der Betonteil-Verbindungselemente 1, 1a und 1b die folgenden Schritte durch:
Zunächst findet eine Erstellung A einer statischen Planung für ein an einer Gebäudefassade anzubringendes auskragendes Betonteil mit Ausgabe des Momenten- und Querkraftverlaufs statt.

Anschließend erfolgt eine Auswahl B von zu dem Momenten- und Querkraftverlauf passenden Betonteil-Verbindungselementen sowie eine Erstellung eines statisch gültigen vorläufigen Einbauplans auf Basis des Momenten- und Querkraftverlaufs.

Danach findet eine Modifikation C des vorläufigen Einbauplans durch einen Abwandlungsalgorithmus zur Erzeugung mindestens eines alternativen Einbauplans statt, wobei der Abwandlungsalgorithmus Werte einer hinsichtlich vorzugsweise mehrerer Dimensionierungskriterien P1 bis P5 parametrierbaren Gütefunktion ermittelt und den vorläufigen Einbauplan derart im Rahmen der statischen Gültigkeit abwandelt, dass die Gütefunktion ein Maximum annimmt, wodurch eine mehrdimensionale sich gegenseitig anpassende Optimierung stattfindet.

Ein nachfolgendes Prüfen D des alternativen Einbauplans auf Zulässigkeit bezüglich baurechtlicher Randbedingungen und/oder technischer Normen dient einer Absicherung des Abwandlungsergebnisses .

Final wird im Rahmen einer Vorzertifizierung E der geprüfte alternative Einbauplan durch eine autorisierte Behörde und/oder einen Sachverständigen im Rahmen einer digitalisierten Vorzertifizierung genehmigt.

Die Erfindung ist nicht beschränkt auf das vorstehend beschriebene bevorzugte Ausführungsbeispiel. Es sind vielmehr auch Abwandlungen hiervon denkbar, welche vom Schutzbereich der nachfolgenden Ansprüche mit umfasst sind. So ist es beispielsweise auch möglich, andere auskragende Betonteile mit den hier interessierenden Betonteil-Verbindungselementen zu verbinden. Diese können anstelle der einzubetonierenden Armierungsstäbe auch eine zumindest einseitige andere Anschlusskonfiguration aufweisen.

### Bezugszeichenliste

- 1: Betonteil-Verbindungselement
- 2: Gebäude
- 3: auskragendes Betonteil
- 4: Gebäudefassade
- 5: Armierungsstab
- 6: Gebäudekante
- 7: Befestigungsanker

- 10: Statikplanungseinheit
- 11: Momenten- und Querkraftverlauf
- 20: Auswahleinheit
- 21: vorläufiger Einbauplan
- 30: Modifikationseinheit
- 31: Abwandlungsalgorithmus
- 32: alternativer Einbauplan
- 40: Vorschriften-Datenbank

- P1-Pn: Dimensionierungskriterien
- a: Gebäudekantenabstand
- b: Armierungsstababstand
- c: Zwischenabstand

## Patentansprüche

**1.** Verfahren zur rechnergestützten Auswahl und Positionierung von Betonteil-Verbindungselementen (1, 1a, 1b), die zwischen einem von einem Gebäude (2) auskragenden Betonteil (3) und einer Gebäudefassade (4) angeordnet werden, umfassend die folgenden Schritte:
- Erstellung (A) einer statischen Planung für ein an einer Gebäudefassade (4) anzubringendes auskragendes Betonteil (3) mit Ausgabe des Momenten- und Querkraftverlaufes,
- Auswahl (B) von zu dem Momenten- und Querkraftverlauf passenden Betonteil-Verbindungselementen (1a', 1b') und Erstellung eines statisch gültigen vorläufigen Einbauplans (21) auf Basis des Momenten- und Querkraftverlaufes,
- Modifikation (C) des vorläufigen Einbauplans (21) durch einen Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (31) Werte einer hinsichtlich mehrerer Dimensionierungskriterien (P1
- P5) parametrierbaren Gütefunktion ermittelt und den vorläufige Einbauplan (21) derart im Rahmen der statischen Gültigkeit abwandelt, dass die Gütefunktion ein Maximum annimmt.

**2.** Verfahren nach Anspruch 1,
**dadurch gekennzeichnet, dass** die mehreren Dimensionierungskriterien (P1 - P5) maßliche, materielle und/oder modellmäßige Kriterien sind.

**3.** Verfahren nach Anspruch 2,
**dadurch gekennzeichnet, dass** ein Dimensionierungskriterium (P1) als Auswahl zwischen verschiedenen Modellen von geeigneten Betonteil-Verbindungselementen (1, 1', 1") ausgebildet ist.

**4.** Verfahren nach Anspruch 2,
**dadurch gekennzeichnet, dass** ein Dimensionierungskriterium (P2) als Zwischenabstand (c) zwischen benachbarten Betonteil-Verbindungselementen (1a, 1b) ausgebildet ist.

**5.** Verfahren nach Anspruch 2,
**dadurch gekennzeichnet, dass** ein Dimensionierungskriterium (P3) als Gebäudekantenabstand (a) zwischen einer Gebäudekante (6) und einem ersten Armierungsstab (5) eines Betonteil-Verbindungselements (1) ausgebildet ist.

**6.** Verfahren nach Anspruch 2,
**dadurch gekennzeichnet, dass** ein Dimensionierungskriterium (P4) als Armierungsstababstand (b) ausgebildet ist.

**7.** Verfahren nach Anspruch 2,
**dadurch gekennzeichnet, dass** ein Dimensionierungskriterium (P5) als Positionierungskoordinaten mindestens eines Befestigungsankers (7, 7a) für einen Hebezeug am Betonteil (1) ausgebildet ist.

**7.** Verfahren nach Anspruch 1,
**dadurch gekennzeichnet, dass** die Umwandlung des vorläufigen Einbauplans (21) in den mindestens einen alternativen Einbauplan (31) ein Prüfen (D) desselben auf Zulässigkeit bezüglich baurechtlicher Randbedingungen und/oder technischer Normen beinhaltet, die in einer Vorschriften-Datenbank (40) hinterlegt sind.

**8.** Verfahren nach Anspruch 1,
**dadurch gekennzeichnet, dass** der alternative Einbauplan (31) in der mit dem Planungsassistenzsystem verbundenen Vorschriften-Datenbank (40) hinterlegt wird, um diesen bei zukünftigen Umwandlungen gleicher oder ähnlicher vorläufiger Einbaupläne (21) als Vorschlag zu berücksichtigen.

**9.** Verfahren nach Anspruch 1,
**dadurch gekennzeichnet, dass** der ausgewählte alternative Einbauplan (31) vor Montage eine Vorzertifizierung (E) auf normkonforme Umsetzung durchläuft.

**10.** Einrichtung zur rechnergestützten Auswahl und Positionierung von Betonteil-Verbindungselementen (1, 1a, 1b), die zwischen einem von einem Gebäude (2) auskragenden Betonteil (3) und einer Gebäudefassade (4) angeordnet sind, umfassend eine Statikplanungseinheit (10) zur Erstellung einer statischen Planung für ein an einer Gebäudefassade (4) anzubringendes auskragendes Betonteil (3) mit Ausgabe des Momenten- und Querkraftverlaufes (11), eine Auswahleinheit (20) zur Bestimmung von zu dem Momenten- und Querkraftverlauf passenden Betonteil-Verbindungselementen (1a', 1b') für die Erstellung eines statisch gültigen vorläufigen Einbauplans (21) auf Basis des Momenten- und Querkraftverlaufes, eine Modifikationseinheit (30) zur Abänderung des vorläufigen Einbauplans (21) durch einen hierin implementierten Abwandlungsalgorithmus (31) zur Erzeugung mindestens eines alternativen Einbauplans (32), wobei der Abwandlungsalgorithmus (31) zur Abwandlung des vorläufigen Einbauplans (21) in den alternativen Einbauplan (32) Werte einer hinsichtlich mehrerer Dimensionierungskriterien (P1 - P5) parametrierbare Gütefunktion ermittelt und den vorläufige Einbauplan (21) derart im Rahmen der statischen Gültigkeit abwandelt, dass die Gütefunktion ein Maximum annimmt.

**11.** Einrichtung nach Anspruch 1,
**dadurch gekennzeichnet, dass** die Betonteil-Verbindungselemente (1, 1a, 1b) zumindest teilweise als digitalisiertes Modell eines tragenden Wärmedämmelements ausgebildet sind.

**12.** Computerprogramm, umfassend Befehle, die bei der Ausführung des Programms durch eine Einrichtung gemäß Anspruch 10, diese veranlassen, die Schritte des Verfahrens gemäß einem der Ansprüche 1 bis 9 auszuführen.

**13.** Computerlesbarer Datenträger, auf dem das Computerprogramm nach Anspruch 12 gespeichert ist.
